# EUROPEAN PATENT SPECIFICATION

(11) **EP 4 631 909 B1**
(45) Date of publication and mention of the grant of the patent: **14.10.2026**
(21) Application number: 24169579.0
(22) Date of filing: 11.04.2024
(51) Int. Cl.: B81C 99/00

(54) **ARRANGEMENT AND METHOD FOR TRANSPORTING MICROMECHANICAL COMPONENTS**
ANORDNUNG UND VERFAHREN ZUM TRANSPORT MIKROMECHANISCHER BAUELEMENTE
DISPOSITIF ET PROCÉDÉ DE TRANSPORT DE COMPOSANTS MICROMÉCANIQUES

(43) Date of publication of application: 15.10.2025
(73) Proprietor: Technische Universität Ilmenau, 98693 Ilmenau (DE)
(72) Inventor: de Oliveira Moreira, Pedro Henrique, 98693 Ilmenau (DE); Jacobs, Heiko, 98693 Ilmenau (DE)
(74) Representative: Rittermann, Marco

(56) References cited:
- US-A1- 2011 006 464

## Description

The present invention concerns an arrangement for transportation of micromechanical components. The arrangement defines a route of transport, on which the micromechanical components can be transported. Furthermore, the present invention concerns a method for transporting micromechanical components.

Known solutions of transporting micromechanical components use robotic pick-and-place, where a robotic arm moves components from point A to point B requiring the steering and translation of the trajectory. These solutions have the disadvantages of the difficulty in handling components with sizes smaller than 100 µm, long operation times when required to transport large numbers of components due to serial operation and also a difficulty with working with non-planar substrates.

Micromechanical components have also been transported in a more limited scope using microfluidics, in which the transport is confined to the interior of channels with sidewalls typically enclosing the component to be transported. However, transported component movement within the microfluidic channel is random in position and orientation. A desired orientation alignment is not enforced during transport; therefore, components can be rotated in many ways during transport.

EP 0 619 253 A1 shows a method of transporting small micro-mechanical parts. A small micromechanical part is placed on the surface of a still liquid and held there on account of the surface tension, wherein a predetermined path is formed. The small micromechanical part is subjected to external forces, by means of which forces the small micro-mechanical part is transported along the predetermined path on the surface of the liquid. The geometry of the liquid surface is formed in such a manner that the small micromechanical part is definitively aligned in terms of its spatial orientation. Means are provided by means of which the spatial position of the small micromechanical part can be definitively set. A platform is held on the surface of a liquid. The platform is transported and positioned there. Within the platform, a small micromechanical part is positioned on the surface of a liquid with respect to the platform.

EP 2 688 093 A1 relates to a method of self-assembly including self-alignment of components on a substrate on the basis of surface tension of liquid solder. A solder stack is composed of an outermost layer of solder on top and at least another layer of solder. The layers of solder having successively increasing melting points from top to bottom. In a first step, the solder stack is heated to melt the outermost layer of solder. This solder layer is used to form a receptor, which adheres to the components, which are self-assembled and self-aligned. In the next step, the solder stack is heated to a temperature further elevated above the melting point of the at least another layer of solder. Thereby a reflow soldering-process is initialized, and the two layers of solder form a mixed solder layer as an alloy. As a consequence, an interconnect between the components and the substrate is formed.

DE 102 44 867 A1 teaches a device that has an arrangement for moving an object in a number of different positions and for fixing the object in a previously achieved position. The arrangement for moving and positioning the object contains a magnetic liquid that interacts with at least one magnetic element. The object is accommodated by the magnetic liquid. It floats on or in the magnetic liquid.

US 2011/0006464 A1 describes a device where a microfluidic channel has a rail formed along its base. The rail may be a structure protruding from the base or it may be a groove extending along the base. An object to be transported has a protrusion or a notch which holds the object in or on the rail while liquid flow in the channel causes the object to move along the rail.

An object of the present invention is to transport micrometre-sized components from a starting point to an ending point with high location precision in a programmable and reliable way. The reliable mass transportation of micrometre-sized objects and components is a subject of interest in multiple areas from microelectronics to biomedicine such as micro sensors, micro-electromechanical systems (MEMS), and microfabrication.

The aforementioned object is achieved by an arrangement according to the enclosed claim 1 and by a method according to the enclosed claim 13.

The arrangement according to the invention aims at a transportation of micromechanical components. These micromechanical components are typically micrometre-sized components that can be referred to as microscopic components. These micromechanical components show preferably dimensions of at most 1 mm. The transport extends from a starting point to an ending point. A length of the transport is preferably at least 100 µm. In further preferred embodiments, this length is at most 10 cm.

The arrangement comprises a substrate that extends on a route of transport. This substrate forms a base for the route of transport from the starting point to the ending point. The route of transport defines a track on which the micromechanical components can be transported.

The arrangement further comprises at least one strip-shaped layer on the substrate defining the extent of a rail on the route of transport. The layer shows the shape of a long strip that extends from the starting point of the route of transport to the ending point of the route of transport. This layer consists of a solid material. This layer forms a base for the rail. Consequently, also the rail extends from the starting point of the route of transport to the ending point of the route of transport.

The arrangement further comprises a liquid or meltable transport substance on the layer. In any case, this transport substance is liquid when the arrangement is in use. If the transport substance is solidified when the arrangement is not in use, this transport substance has to be melted before using the arrangement. The transport substance forms a rail, on which the micromechanical components are transported. The route of transport comprises the only one rail or a plurality of the rails that are preferably parallel. That is to say the route of transport delineates the path for transporting the micromechanical components and the route of transport is formed by one or more of the preferably parallel rails. The liquid or melted transport substance is bound to the strip-shaped layer so that this substance does not flow on areas of the substrate that are not coated with the strip-shaped layer. Hence, the transport substance only coats the strip-shaped layer. For this, an interfacial tension between the transport substance and the solid material of the layer is smaller than an interfacial tension between the transport substance and the substrate. In other words, a surface tension of the transport substance against the solid material of the layer is smaller than against the substrate. The liquid or melted transport substance adheres to the solid material of the strip-shaped layer whereas the liquid or melted transport substance is rejected by the solid material of the substrate. Therefore, the liquid or melted transport substance and the strip-shaped layer have the same extent in the plane of the substrate.

The micromechanical components to be transported can be placed on the liquid or melted transport substance. The micromechanical components remain on the liquid or melted transport substance on the basis of surface tension of the transport substance. Without any external force, the micromechanical components cannot fall from the liquid or melted transport substance. Hence, the micromechanical components float on the surface of the liquid or melted transport substance. Moreover, the micromechanical components are attached to the liquid or melted transport substance by surface free energy minimization which holds the micromechanical components on the rails and prevents de-railing.

The arrangement further comprises at least one means for applying a driving force to a micromechanical component that floats on the liquid or melted transport substance. By this means, the micromechanical component can be driven to be transported along the rail formed by the liquid or melted transport substance. The at least one micromechanical component shows a speed of its movement that is preferably between 1 mm/s and 10,000 mm/s and, more preferably, between 200 mm/s and 2,000 mm/s.

A special benefit of the arrangement according to the invention is that it provides liquid micro rails for guiding and transporting the micromechanical components. Once in contact with the liquid or melted transport substance, the micromechanical component to be transported is connected to the liquid or melted transport substance by free energy minimization. The liquid or melted transport substance acts as a lubricating bearing allowing the micromechanical component to slide along the rail while preventing motion in other directions. By applying a driving force to the micromechanical component, its movement along the rail can be controlled. The trajectory of this individual component can be programmed by locally manipulating the driving forces and rail design.

A further benefit of the arrangement according to the invention is that the at least one micromechanical component stays on the route of transport with no need for steering, the at least one rail itself confines its motion to the desired direction. The invention provides a liquid micro rail that utilizes a patterned liquid layer as an interface between the solid substrate and the transported micromechanical components. The liquid or melted transport substance acts as a lubrication layer that allows the at least one micromechanical component to slide along the route of transport while both guiding the micromechanical component and preventing it from leaving the rail due to an internal interfacial free energy minimization mechanism.

A further benefit of the arrangement according to the invention is that it allows a reliable parallel transportation of the micromechanical components from a starting point to a destination point as well as simultaneous independent transportation of different types of such micromechanical components by programming component sensitive trajectories. These permit the creation of conveyor belt like systems for the mass parallel transportation of different micromechanical components. Additionally, the liquid or melted rails are compatible with both air and liquid based environments, with non-planar and non-rigid substrates and not limited to the closed or semi-closed channels used exclusively in microfluidic approaches.

A further benefit of the arrangement according to the invention is that an enforcement of the orientation of the micromechanical component during transport is not necessary. Considering a cubic component as an example, apart from a desired orientation of top side up, any other rotated orientation such as top side down, right side up, etc. is impossible during transport. This orientation control is not limited to cubic components but is compatible with any other three-dimensional geometry containing faces or regions that can be patterned including cylinders, pyramids, or spheres.

In preferred embodiments, the substrate is planar since channels, trenches, or grooves are not necessary according to the invention. Likewise, the at least one strip-shaped layer is planar since channels, trenches, or grooves are not necessary according to the invention. The strip-shaped layer is preferably formed by a coating of the substrate.

In preferred embodiments, the substrate consists of silicon. There are fully developed techniques for coating silicon by a layer such as the strip-shaped layer. Also, other materials can be used for the substrate.

In preferred embodiments, the liquid or meltable transport substance is a solder, a liquid metal, an oil, or water. The solder is preferably Field's metal that is a fusible alloy that becomes liquid at approximately 62 °C and is a eutectic alloy of bismuth, indium, and tin.

In preferred embodiments, the strip-shaped layer contains copper, especially, if the meltable transport substance is a solder or a liquid metal. Alternatively, the strip-shaped layer is preferably hydrophobic, especially, if the liquid transport substance is an oil. Alternatively, the strip-shaped layer is preferably hydrophilic, especially, if the liquid transport substance contains water. The at least one strip-shaped layer shows a width that is preferably smaller than 1 mm and, more preferably, smaller than 500 µm, and, even more preferably, smaller than 200 µm. The at least one strip-shaped layer shows a thickness that is preferably smaller than 10 µm and, more preferably, smaller than 1 µm.

In preferred embodiments, the arrangement further comprises a tube that covers the substrate and the transport substance that forms the rail. This tube protects the substrate and the rail as well as the micromechanical components on the rail. Furthermore, the tube ensures an environment that is suitable for the transport of the micromechanical components. This tube can be made of glass or transparent plastic or opaque material.

The at least one means for applying a driving force is preferably formed by a gaseous or liquid medium, which flows through the tube. This flowing medium guides the micromechanical components on the rail. Direction and velocity of the transport of the micromechanical components result from the direction and flow velocity of the medium. The arrangement preferably comprises at least one pump for pumping the medium through the tube. This pump forms a part of the means for applying a driving force. The medium comprises preferably air or water. In the case of water an average flow speed between 200 mm/s and 2,000 mm/s is preferred. In the case where the meltable substance is solder the medium comprises preferably water and an acid as preferably hydrochloric acid or citric acid.

The medium is preferably heated in order to melt the meltable transport substance, especially, if the transport substance is a solder like Field's metal. For this, the arrangement preferably comprised a heating element for heating the medium. In this case, the medium is preferably liquid and preferably comprises water. This liquid medium is heated to over the melting point of the meltable transport substance, preferably to over 62 °C if the meltable transport substance is Field's metal.

In preferred embodiments, the at least one means for applying a driving force is formed by a permanent magnet, by an electromagnet, or by an actuator for inclining the substrate. The electromagnet or a plurality of the electromagnets can control the movement of the micromechanical components. The actuator for inclining the substrate allows a controlled inclining of the substrate including the rail. An angle of the inclination is preferably smaller than 15 degrees and, more preferably, smaller than 5 degrees. By this means, the at least one micromechanical component is moved due to gravity.

In preferred embodiments, the strip-shaped layer has at least one discontinuity on the route of transport, so the rail formed by the liquid or meltable transport substance has also at least one discontinuity, so that a micromechanical component to be transported has to overcome an energy barrier in order to pass the discontinuity. This at least one discontinuity can be used for controlling the movement of the micromechanical component. When the micromechanical component arrives at the discontinuity, the micromechanical component stops there until a higher driving force is applied to the micromechanical component by the means for applying a driving force.

The at least one discontinuity shows a length that is preferably smaller than 100 µm. The length is preferably larger than 1 µm, and more preferably larger than 5 µm.

The at least one discontinuity of the strip-shaped layer is preferably formed by a narrowing or by a gap. The length of the gap is preferably smaller than a length of the smallest micromechanical component to be transported.

The strip-shaped layer has preferably a plurality of the discontinuities on the route of transport. These discontinuities are preferably equally spaced. Between two sequent discontinuities, a segment of the strip-shaped layer is formed. Each of these segments shows a length that is preferably between 100 µm and 10 mm.

In preferred embodiments, two parallel strip-shaped layers of the strip-shaped layers define the extent of two of the rails on the route of transport. Hence, the route of transport is formed by at least two parallel rails. The micromechanical component is transported by both rails jointly. The distance of the two rails is preferably smaller than a width of the smallest micromechanical component to be transported, so that both rails can carry the smallest micromechanical component. The micromechanical components can be carried more reliably by the at least two parallel rails.

In the preferred embodiments having at least two parallel rails and discontinuities of the strip-shaped layer, the discontinuities of the two rails are offset, so that on each point of the route of transport is at most one of the discontinuities. In other words, there is not any point of the route of transport on which both rails have discontinuities. This ensures that the transported micromechanical component never completely loses contact with both rails while passing one of the discontinuities.

The arrangement is not limited to one route of transport. The arrangement preferably comprises at least two of the routes of transport. These routes of transport can form a network of transport. For this, the arrangement preferably comprises at least one means for applying a selectable switching force to the micromechanical component to be transported for switching this micromechanical component from a first of the routes of transport to a second of the routes of transport. Hence, this means shows the function of a railway switch. The means for applying a selectable switching force to the micromechanical component to be transported is preferably located at one of the discontinuities of the rails. Preferably, the arrangement comprises a plurality of these means for applying a selectable switching force to the micromechanical component to be transported.

In preferred embodiments, the means for applying a selectable switching force to the micromechanical component is formed by a permanent magnet, by an electromagnet, by an actuator for inclining the substrate, or by a gaseous or liquid medium that flows across the rail. This flowing medium guides the micromechanical component from the first of the two routes of transport to the second of the two routes of transport. The arrangement preferably comprises at least one switching pump for pumping the medium across the rail. This switching pump forms a part of the means for applying a switching force.

The method according to the invention aims at transporting micromechanical components on the arrangement according to the invention. In a step of the method, at least one micromechanical component is put on the liquid or melted transport substance. Consequently, the micromechanical component lies and adheres on the liquid or melted transport substance. In other words, the micromechanical component lies and adheres on the liquid rail. If no force acts on the micromechanical component, this micromechanical component is at rest. In a further step, a driving force is applied to the micromechanical component by the means for applying a driving force. Consequently, the micromechanical component moves along the rail.

The method is preferably applied to a preferred embodiment of the arrangement according to the invention. Preferably, the method shows features that are described in connection with the arrangement according to the invention and its preferred embodiments.

In preferred embodiments, the method is applied to the arrangement with two of the routes of transport and the means for applying a selectable switching force to the micromechanical component. In this case, the method preferably comprises a step of applying a switching force to the micromechanical component by the means for applying a selectable switching force for switching this micromechanical component from the first route of transport to the second route of transport.

In preferred embodiments, at least two different of the micromechanical components are put on the liquid or melted transport substance. Consequently, the different micromechanical components lie and adhere to the liquid or melted transport substance. In other words, the different micromechanical components lie and adhere to the liquid rail. Preferably, the at least two different micromechanical components are different in terms of their functionality, their mass, their shape, and/or their size. For instance, a plurality of the micromechanical components of a first type and a plurality of the micromechanical components of a second type are transported. These micromechanical components can be sorted according to their type by the means of applying a selectable switching force in order to guide the micromechanical components to different of the routes of transport. For this, the method preferably further comprises the following steps. A first of the two different micromechanical components is detected. This detected first micromechanical component is allowed to pass the means for applying a selectable switching force so that the first micromechanical component remains on the first route of transport. The transport of the first micromechanical component is continued on the first route of transport. Hence, the first micromechanical component or the micromechanical components of the first type are permanently transported on the first route of transport. For this, the means for applying a selectable switching force remains switched off while the first micromechanical component is passing this means or this means applies a selected force to the first micromechanical component so that the first micromechanical component remains on the first route of transport. In a further step, a second of the two different micromechanical components is detected. A selected switching force is applied to the detected second micromechanical component by the means for applying a selectable switching force so that the second micromechanical component is switched from the first route of transport to the second route of transport. Hence, the second micromechanical component or the micromechanical components of the second type are initially transported on the first route of transport and subsequently transported on the second route of transport.

In another preferred embodiment, the different micromechanical components are sorted according to their type by the means of applying a constant switching force in order to guide the different micromechanical components to different of the routes of transport. For this, the different micromechanical components are force-sensitive. The at least two different micromechanical components are different in terms of their sensitivity to the switching force. That means the first micromechanical component is not sensitive to the switching force or has reduced sensitivity to the switching force. The second micromechanical component is sensitive to the switching force or has increased sensitivity to the switching force. For example, for a magnetic switching force the first micromechanical component is non-ferromagnetic while the second micromechanical component is ferromagnetic. For another example, for a drag-based switching force the first micromechanical component preferably has a shape with a small drag coefficient while the second micromechanical component has a shape with a high drag coefficient. For this, the method preferably further comprises the following steps. A first of the two different micromechanical components, a switch force non-sensitive micromechanical component, passes the means for applying a constant switching force and does not interact so that the first micromechanical component remains on the first route of transport. In a further step, a second of the two different micromechanical components, a switch force-sensitive micromechanical component, passes the means for applying a constant switching force and is switched from the first route of transport to the second route of transport. Hence, the second micromechanical component or the micromechanical components of the second type are initially transported on the first route of transport and subsequently transported on the second route of transport.

Additional advantages, details and refinements of the invention will become apparent from the following description of a preferred embodiment of the invention, making reference to the drawing. There are shown:
- Fig. 1:: a first preferred embodiment of an arrangement according to the invention in a principal view;
- Fig. 2:: a second preferred embodiment of the arrangement according to the invention in a principal view in four temporal phases during its operation;
- Fig. 3:: a third preferred embodiment of the arrangement according to the invention in a principal view in four temporal phases during its operation;
- Fig. 4:: a fourth preferred embodiment of the arrangement according to the invention in a principal view;
- Fig. 5:: a fifth preferred embodiment of the arrangement according to the invention with two routes of transport in a perspective view;
- Fig. 6:: a sixth preferred embodiment of the arrangement according to the invention with two routes of transport in a perspective view;
- Fig. 7:: a seventh preferred embodiment of the arrangement according to the invention with a plurality of routes of transport in a chamber in a perspective view;
- Fig. 8:: an eight preferred embodiment of the arrangement according to the invention with a route of transport composed of two rails in a top view;
- Fig. 9:: a ninth preferred embodiment of the arrangement according to the invention with two routes of transport in a perspective view; and
- Fig. 10:: a tenth preferred embodiment of the arrangement according to the invention with two routes of transport in a perspective view.

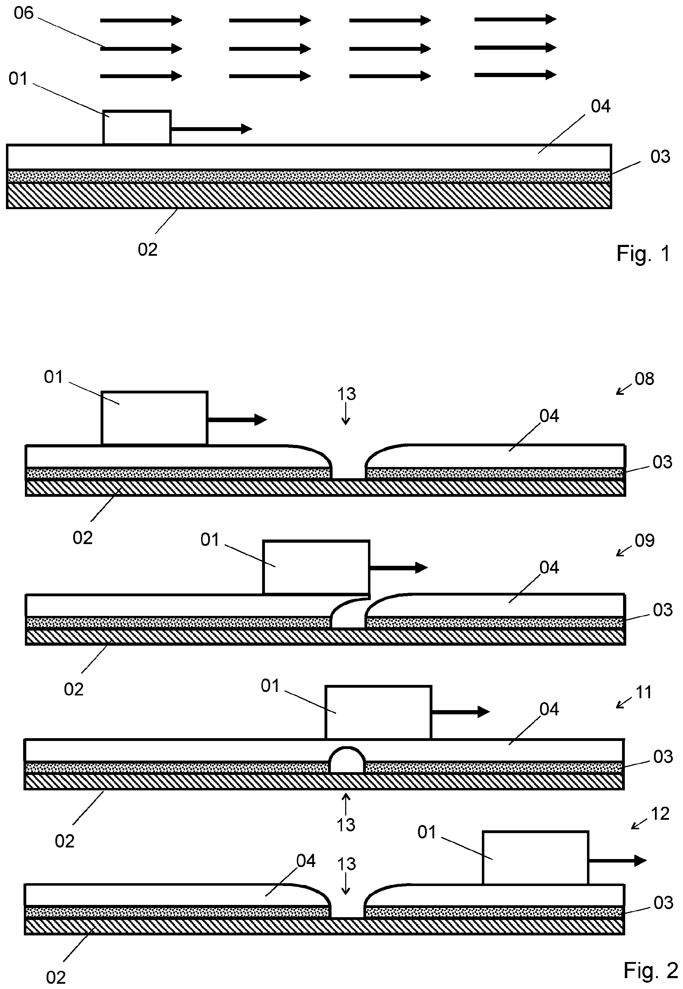

Fig. 1 shows a first preferred embodiment of an arrangement according to the invention in a principal view. This arrangement aims at transporting a micromechanical component 01. The micromechanical component 01 can be a microelectronic chip, for example. The arrangement comprises a planar substrate 02 that preferably consists of silicon. There is a strip-shaped layer 03 on the substrate 02. This layer 03 preferably consists of copper. Furthermore, there is a meltable transport substance 04 on the layer 03. This meltable transport substance 04 preferably consists of a solder that melts at a temperature below 100 °C as Field's metal, for example. When the arrangement is in use, the meltable transport substance 04 is melted. The melted transport substance 04 is bound to the strip-shaped layer 03 and will not flow to other parts of the substrate 02, on which the strip-shaped layer 03 does not extend. Hence, the melted transport substance 04 shows the same extensions in the horizontal plane as the strip-shaped layer 03. The melted transport substance 04 forms a rail that defines a route of transport. The micromechanical component 01 to be transported is put on the melted transport substance 04. Hence, the micromechanical component 01 is connected to the melted transport substance 04 by free energy minimization. The melted transport substance 04 acts as a lubricating bearing allowing the micromechanical component 01 to slide along the strip-shaped melted transport substance 04 while preventing motion in other directions. A streaming liquid medium is imaged by arrows 06. This streaming liquid medium 06 can contain water and an acid, for example. This streaming liquid medium 06 effects a driving force to the micromechanical component 01 resulting in a movement of the micromechanical component 01 in the direction of the streaming liquid medium 06.

Fig. 2 shows a second preferred embodiment of the arrangement according to the invention in a principal view in a first temporal phase 08, in a second temporal phase 09, in a third temporal phase 11, and in a fourth temporal phase 12 during its operation corresponding to a preferred embodiment of a method according to the invention. Basically, the second preferred embodiment is the same as the first preferred embodiment shown in Fig. 1. In contrast to the first preferred embodiment shown in Fig. 1, the strip-shaped layer 03 of the second preferred embodiment comprises a gap 13. This gap 13 is also present in the melted transport substance 04. The micromechanical component 01 has to overcome an energy barrier in order to pass the gap 13. In the first temporal phase 08, the micromechanical component 01 moves towards the gap 13. In the second temporal phase 09, the micromechanical component 01 has reached the gap 13. A higher driving force is necessary so that the micromechanical component 01 can overcome the gap 13. In the third temporal phase 11, the higher driving force acts on the micromechanical component 01 so that the micromechanical component 01 overcomes the gap 13. In the fourth temporal phase 12, the micromechanical component 01 has overcome the gap 13.

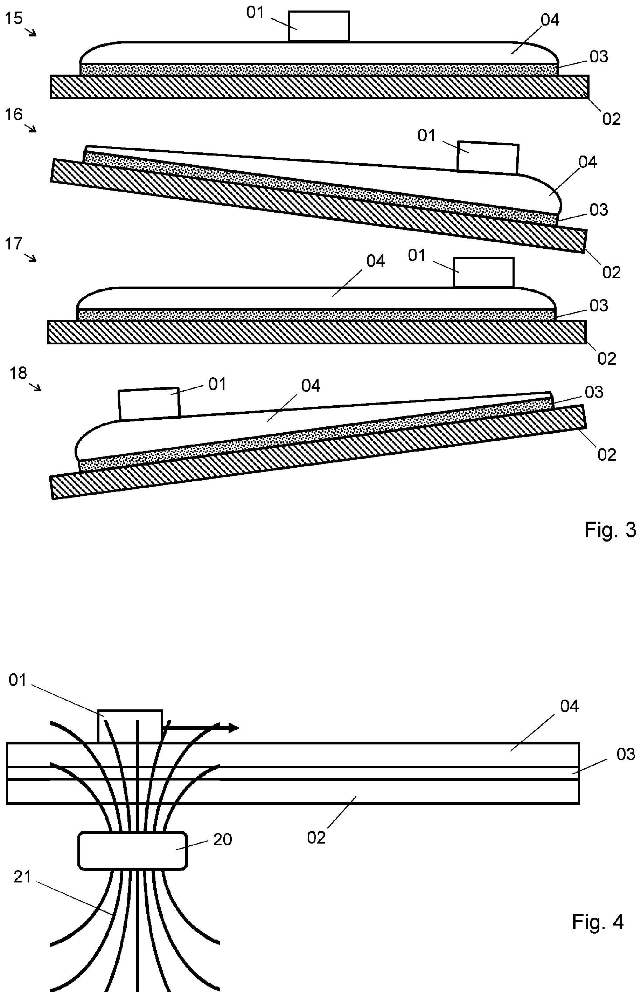

Fig. 3 shows a third preferred embodiment of the arrangement according to the invention in a principal view in a first temporal phase 15, in a second temporal phase 16, in a third temporal phase 17, and in a fourth temporal phase 18 during its operation corresponding to a preferred embodiment of the method according to the invention. Basically, the third preferred embodiment is the same as the first preferred embodiment shown in Fig. 1. In contrast to the first preferred embodiment shown in Fig. 1, the third preferred embodiment comprises an actuator (not shown) for inclining the substrate 02. In the first temporal phase 15, the substrate 02 is aligned horizontally. It is not inclined. Hence, the strip-shaped layer 03 and the melted transport substance 04 are also aligned horizontally. The micromechanical component 01 rests since no driving force acts on it. Especially, the weight of the micromechanical component 01 acts perpendicular to the melted transport substance 04 so that the micromechanical component 01 is not moved by gravity. In the second temporal phase 16, the substrate 02 has been tilted to the right side by the actuator (not shown). Hence, the melted transport substance 04 has been flowed to the right side, too. Since the melted transport substance 04 is bound to the strip-shaped layer 03, the melted transport substance 04 is inclined. Consequently, the micromechanical component 01 moves down on the surface of the melted transport substance 04 to the right side due to gravity. In the third temporal phase 17, the substrate 02 has been aligned horizontally again by the actuator (not shown). Hence, the melted transport substance 04 has been aligned horizontally again, too. The micromechanical component 01 rests on its position on the right side. In the fourth temporal phase 18, the substrate 02 has been tilted to the left side by the actuator (not shown). Hence, the melted transport substance 04 has been flowed to the left side, too. Since the melted transport substance 04 is bound to the strip-shaped layer 03, the melted transport substance 04 is inclined. Consequently, the micromechanical component 01 moves down on the surface of the melted transport substance 04 to the left side due to gravity.

Fig. 4 shows a fourth preferred embodiment of the arrangement according to the invention in a principal view. Basically, the fourth preferred embodiment is the same as the first preferred embodiment shown in Fig. 1. In contrast to the first preferred embodiment shown in Fig. 1, the fourth preferred embodiment comprises an electromagnet 20 that acts as a means for applying a driving force to a micromechanical component 01. A controllable magnetic field 21 can be generated using the electromagnet 20. The controllable magnetic field 21 acts on the micromechanical component 01 so that the micromechanical component 01 will be moved.

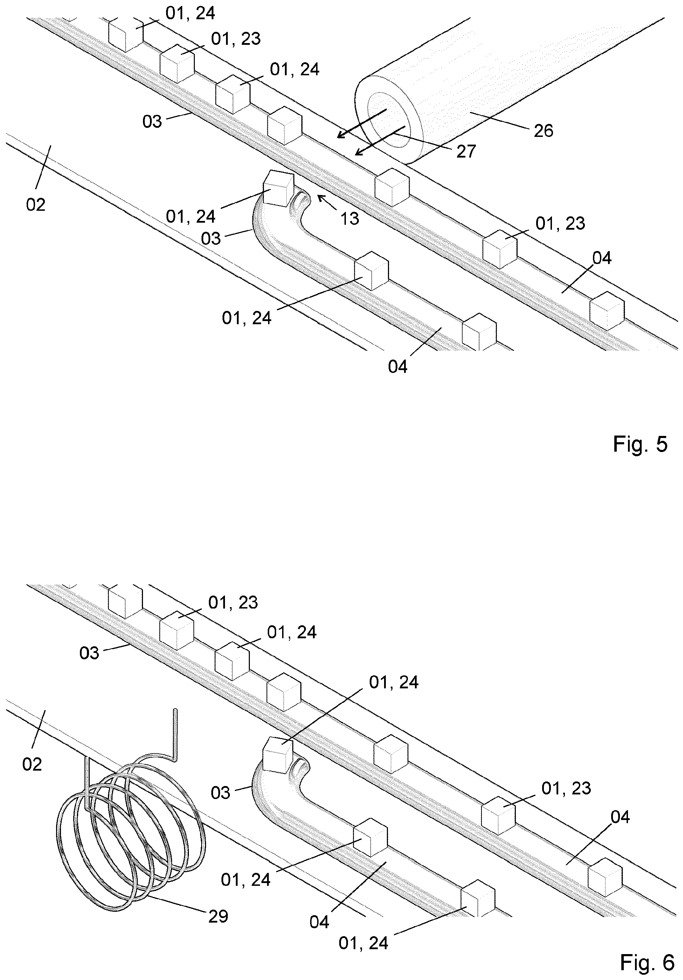

Fig. 5 shows a fifth preferred embodiment of the arrangement according to the invention with two railed routes of transport in a perspective view. This fifth preferred embodiment comprises the substrate 02, two of the strip-shaped layers 03 and accordingly two portions of the melted transport substance 04 as the first preferred embodiment shown in Fig. 1 resulting in two same parallel routes of transport, the first route of transport and the second route of transport. The second route of transport is almost connected to the first route of transport separated only by a discontinuity in form of the gap 13. On the melted transport substance 04 forming the first of the two routes of transport, a plurality of the micromechanical components 01 is transported. This plurality comprises the micromechanical components 01 of a first type 23 and the micromechanical components 01 of a second type 24. The arrangement comprises an air blower 26 positioned facing the gap 13 that acts as a means for applying a selectable switching force to the micromechanical components 01 for switching the micromechanical components 01 of the second type 24 from the first route of transport to the second route of transport. When one of the micromechanical components 01 of the second type 24 reaches the gap 13 and passes the air blower 26, the air blower 26 blows air that is imaged by arrows 27 on this micromechanical component 01 so that this micromechanical component 01 of the second type 24 crossed the gap 13 to the second route of transport. When one of the micromechanical components 01 of the first type 23 reaches the gap 13 and passes the air blower 26, the air blower 26 does not blow air on this micromechanical component 01 so that this micromechanical component 01 of the first type 23 remains on the first route of transport.

Fig. 6 shows a sixth preferred embodiment of the arrangement according to the invention with two railed routes of transport in a perspective view. Basically, this sixth preferred embodiment is the same as the fifth preferred embodiment shown in Fig. 5. In contrast to the fifth preferred embodiment shown in Fig. 5, the arrangement comprises an electromagnet 29 instead of the air blower 26 (shown in Fig. 5). The electromagnet 29 acts as a means for applying a selectable switching force to the micromechanical components 01 for switching the micromechanical components 01 of the second type 24 from the first route of transport to the second route of transport. The effect of the electromagnet 29 is the same as of the air blower 26 shown in Fig. 5.

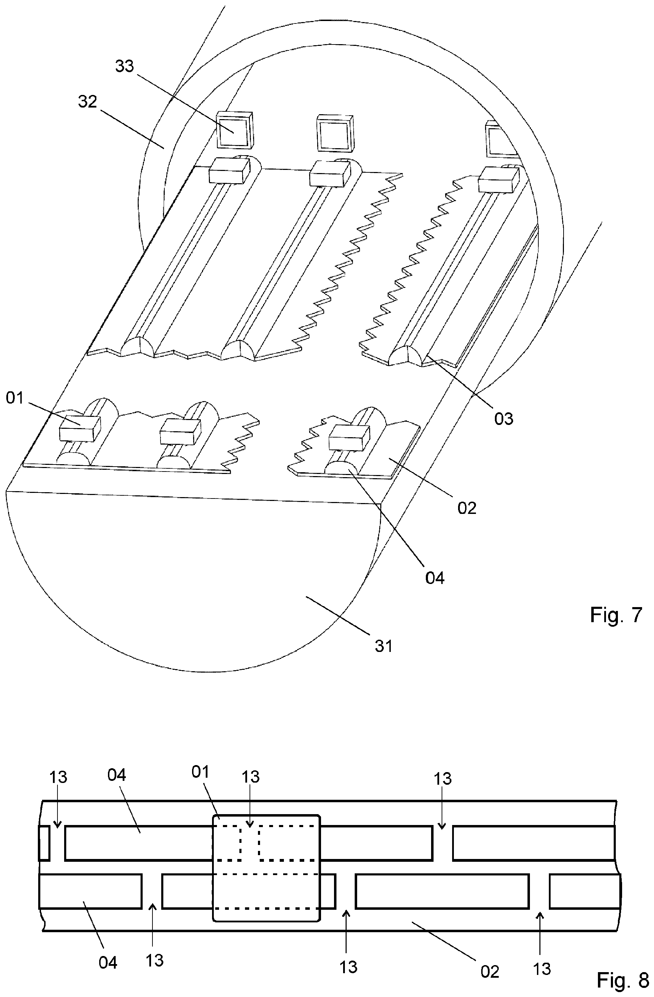

Fig. 7 shows a seventh preferred embodiment of the arrangement according to the invention with a plurality of railed routes of transport in a perspective view. This seventh preferred embodiment comprises the substrate 02, a plurality of the strip-shaped layers 03 and accordingly a plurality of the melted transport substance 04 as the first preferred embodiment shown in Fig. 1 resulting in a plurality of same parallel railed routes of transport. The substrate 02 is located on a semi-cylindrical substrate holder 31. All these parts are located in a hollow cylindrical glass chamber 32 that forms a tube. Within the hollow cylindrical glass chamber 32, heated water (not shown) streams parallelly to the axis of the hollow cylindrical chamber 32. The heat of the heated water (not shown) melts the meltable transport substance 04. The streaming water (not shown) also affects a driving force to the micromechanical components 01 resulting in a movement of the micromechanical components 01 in the direction of the streaming water (not shown). Solder wettable contacts 33 of gold are located above the portions of the melted transport substance 04.

The hollow cylindrical chamber 32 shows an external diameter of 10 mm and an internal diameter of 5 mm, for example. The semi-cylindrical substrate holder 31 shows a diameter of 5 mm, for example. The substrate 02 shows a thickness of 0.5 mm, for example. The micromechanical components 01 show dimensions of 500 µm × 500 µm × 200 µm, for example. The flow speed of the streaming water (not shown) can be between 1 ml/s and 20 ml/s, for example. This may result in a speed of the movement of the micromechanical components 01 between 1 mm/s and 2,000 mm/s, for example.

Fig. 8 shows an eight preferred embodiment of the arrangement according to the invention in a top view. This eighth preferred embodiment comprises the substrate 02, two of the strip-shaped layers 03 and accordingly two portions of the melted transport substance 04 as the first preferred embodiment shown in Fig. 1 resulting in a railed route of transport composed of two same parallel rails. This eighth preferred embodiment comprises a plurality of the gaps 13 as the second preferred embodiment shown in Fig. 2. Each of the micromechanical components 01 occupies both rails due to the dimensions of the micromechanical components 01 and the rails formed by the melted transport substance 04.

The gaps 13 are equally spaced. The gaps 13 are offset on the two rails so that each of the micromechanical components 01 always contacts at least one of the two rails formed by the melted transport substance 04 during its transportation.

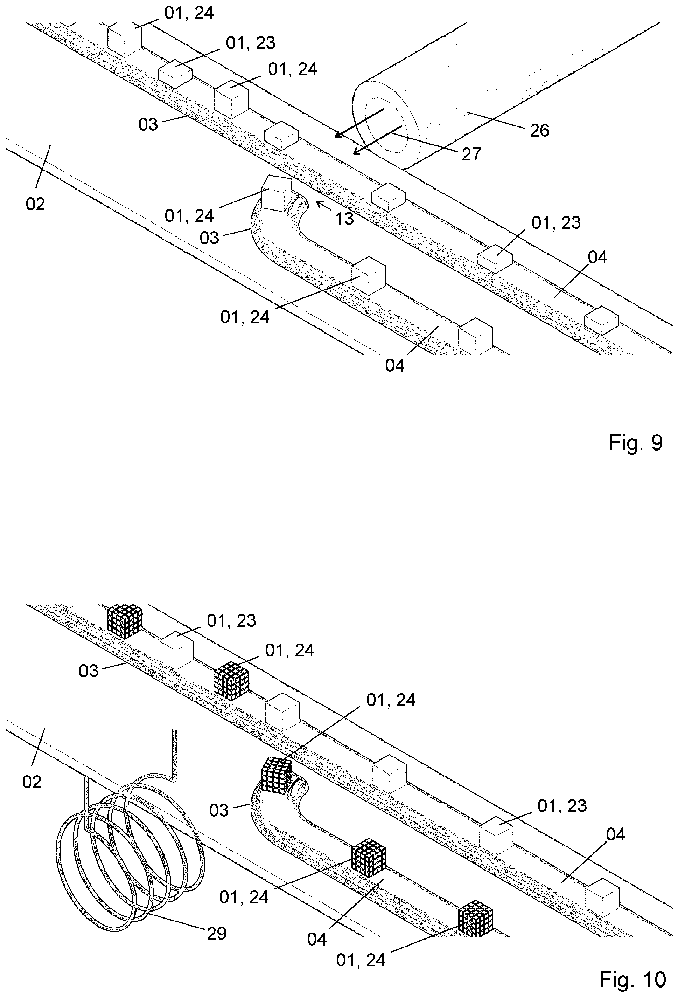

Fig. 9 shows a ninth preferred embodiment of the arrangement according to the invention with two railed routes of transport in a perspective view. Basically, this ninth preferred embodiment is the same as the fifth preferred embodiment shown in Fig. 5. In contrast to the fifth preferred embodiment shown in Fig. 5, the air blower 26 is always active and the difference between the first type 23 and second type 24 of the micromechanical components 01 is their sensitivity to the switching force. The micromechanical components 01 of the first type 23 are flat and have a small drag coefficient and are therefore less sensitive to the switching drag force. The micromechanical components 01 of the second type 24 are taller and have a large drag coefficient and are therefore more sensitive to the switching drag force. The micromechanical components 01 of the first type 23 pass through the air blower 26 without switching the routes of transport and continue being transported by the first route of transport. The micromechanical components 01 of the second type 24 pass through the air blower 26 and the drag force is enough to cause a switch to the second route of transport.

Fig. 10 shows a tenth preferred embodiment of the arrangement according to the invention with two railed routes of transport in a perspective view. Basically, this tenth preferred embodiment is to the sixth embodiment the same that the ninth embodiment is to the fifth preferred embodiment. In contrast to the ninth preferred embodiment shown in Fig. 9, the arrangement comprises an electromagnet 29 instead of the air blower 26 (shown in Fig. 9). The micromechanical components 01 of first type 23 and the micromechanical components 01 of the second type 24 have different sensitivities to the magnetic switching force. The micromechanical components 01 of the first type 23 are paramagnetic and insensitive to the magnetic switching force. The micromechanical components 01 of the second type 24 are ferromagnetic and sensitive to the magnetic switching force.

### List of Reference Numerals

- 01: micromechanical component
- 02: substrate
- 03: strip-shaped layer
- 04: meltable transport substance
- 05: -
- 06: streaming liquid medium
- 07: -
- 08: first temporal phase
- 09: second temporal phase
- 10: -
- 11: third temporal phase
- 12: fourth temporal phase
- 13: gap
- 14: -
- 15: first temporal phase
- 16: second temporal phase
- 17: third temporal phase
- 18: fourth temporal phase
- 19: -
- 20: electromagnet
- 21: magnetic field
- 22: -
- 23: first type of micromechanical components
- 24: second type of micromechanical components
- 25: -
- 26: air blower
- 27: blown air
- 28: -
- 29: electromagnet
- 30: -
- 31: substrate holder
- 32: chamber
- 33: contact

## Claims

1. Arrangement for transportation of micromechanical components (01), wherein the arrangement comprises:
- a substrate (02) that extends on a route of transport;
- at least one strip-shaped layer (03) on the substrate (02) defining the extent of a rail on the route of transport, wherein the layer (03) consists of a solid material;
- a liquid or meltable transport substance (04) on the strip-shaped layer (03);
- at least one means (06; 20; 21) for applying a driving force to a micromechanical component (01) that floats on the transport substance (04) and
**characterised in that** the transport substance (04) forms a rail, and wherein an interfacial tension between the transport substance (04) and the solid material of the strip-shaped layer (03) is smaller than an interfacial tension between the transport substance (04) and the substrate (02).

2. Arrangement according to claim 1, **characterized in that** the substrate (02) and the layer (03) are planar.

3. Arrangement according to claim 1 or 2, **characterized in that** the liquid or meltable transport substance (04) is a solder, a liquid metal, an oil, or water.

4. Arrangement according to one of the claims 1 to 3, **characterized in that** it further comprises a tube (32) that covers the substrate (02) and the transport substance (04) that forms the rail.

5. Arrangement according to claim 4, **characterized in that** the at least one means for applying a driving force is formed by a gaseous or liquid medium (06), which flows through the tube (32).

6. Arrangement according to claim 5, **characterized in that** it further comprises a heating element for heating the gaseous or liquid medium (06) so that the meltable transport substance (04) can be melted.

7. Arrangement according to one of the claims 1 to 6, **characterized in that** the at least one means for applying a driving force is formed by a permanent magnet, by an electromagnet (20), or by an actuator for inclining the substrate (02).

8. Arrangement according to one of the claims 1 to 7, **characterized in that** the strip-shaped layer (03) has at least one discontinuity (13) on the route of transport, so the rail formed by the liquid or meltable transport substance (04) has also at least one discontinuity, so a micromechanical component (01) to be transported has to overcome an energy barrier.

9. Arrangement according to claim 8, **characterized in that** the at least one discontinuity of the strip-shaped layer (03) is formed by a narrowing or a gap (13).

10. Arrangement according to one of the claims 1 to 9, **characterized in that** two parallel strip-shaped layers (03) of the strip-shaped layers (03) define the extent of two of the rails on the route of transport.

11. Arrangement according to claim 10, which refers back to claim 8 or 9, **characterized in that** the discontinuities (13) of the two rails are offset, so that on each point of the route of transport is at most one of the discontinuities (13).

12. Arrangement according to one of the claims 1 to 11, **characterized in that** it comprises two of the routes of transport and a means (26; 27; 29) for applying a selectable switching force to the micromechanical component (01) to be transported for switching the micromechanical component (01) from a first of the two routes of transport to a second of the two routes of transport.

13. Method for transporting micromechanical components (01) on an arrangement according to one of the claims 1 to 12, wherein that method comprises the following steps:
- putting at least one micromechanical component (01) on the liquid or melted transport substance (04); and
- applying a driving force to the micromechanical component (01) by the means (06; 20; 21) for applying a driving force to a micromechanical component (01).

14. Method according to claim 13, **characterized in that** the arrangement according to claim 12 is used for transporting the micromechanical components (01), wherein the method further comprises the following step:
- applying a switching force to the micromechanical component (01) by the means (26; 27; 29) for applying a selectable switching force for switching this micromechanical component (01) from the first route of transport to the second route of transport.

15. Method according to claim 14, **characterized in that** at least two different of the micromechanical components (01) are put on the liquid or melted transport substance (04), wherein the method further comprises the following steps:
- detecting a first of the two different micromechanical components (01);
- letting the detected first micromechanical component (01) passing the means (26; 27; 29) for applying a selectable switching force so that the first micromechanical component (01) remains on the first route of transport;
- detecting a second of the two different micromechanical components (01); and
- applying a selected switching force to the detected second micromechanical component (01) by the means (26; 27; 29) for applying a selectable switching force so that the second micromechanical component (01) is switched from the first route of transport to the second route of transport.

## Patentansprüche

1. Anordnung zum Transport von mikromechanischen Bauelementen (01), wobei die Anordnung Folgendes umfasst:
- ein Substrat (02), das sich auf einem Transportweg erstreckt;
- mindestens eine streifenförmige Schicht (03) auf dem Substrat (02), die die Ausdehnung einer Schiene auf dem Transportweg definiert, wobei die Schicht (03) aus einem Feststoffmaterial besteht;
- eine Flüssigkeit oder schmelzbare Transportsubstanz (04) auf der streifenförmigen Schicht (03);
- mindestens ein Mittel (06; 20; 21) zum Anwenden einer Antriebskraft auf ein mikromechanisches Bauelement (01), das auf der Transportsubstanz (04) schwimmt; und
**dadurch gekennzeichnet, dass** die Transportsubstanz (04) eine Schiene bildet, und wobei eine Grenzflächenspannung zwischen der Transportsubstanz (04) und dem Feststoffmaterial der streifenförmigen Schicht (03) geringer als eine Grenzflächenspannung zwischen der Transportsubstanz (04) und dem Substrat (02) ist.

2. Anordnung nach Anspruch 1, **dadurch gekennzeichnet, dass** das Substrat (02) und die Schicht (03) ebenflächig sind.

3. Anordnung nach Anspruch 1 oder 2, **dadurch gekennzeichnet, dass** die Flüssigkeit oder die schmelzbare Transportsubstanz (04) ein Lot, ein Flüssigmetall, ein Öl oder Wasser ist.

4. Anordnung nach einem der Ansprüche 1 bis 3, **dadurch gekennzeichnet, dass** sie ferner ein Rohr (32) umfasst, das das Substrat (02) und die Transportsubstanz (04), die die Schiene bildet, bedeckt.

5. Anordnung nach Anspruch 4, **dadurch gekennzeichnet, dass** das mindestens eine Mittel zum Anwenden einer Antriebskraft durch ein gasförmiges oder flüssiges Medium (06), das durch das Rohr (32) strömt, gebildet wird.

6. Anordnung nach Anspruch 5, **dadurch gekennzeichnet, dass** sie ferner ein Heizelement zum Erwärmen des gasförmigen oder flüssigen Mediums (06) umfasst, sodass die schmelzbare Transportsubstanz (04) geschmolzen werden kann.

7. Anordnung nach einem der Ansprüche 1 bis 6, **dadurch gekennzeichnet, dass** das mindestens eine Mittel zum Anwenden einer Antriebskraft durch einen Permanentmagnet, durch einen Elektromagnet (20) oder durch einen Aktuator zum Neigen des Substrats (02) gebildet wird.

8. Anordnung nach einem der Ansprüche 1 bis 7, **dadurch gekennzeichnet, dass** die streifenförmige Schicht (03) mindestens eine Unterbrechung (13) auf dem Transportweg aufweist, sodass die Schiene, die durch die flüssige oder schmelzbare Transportsubstanz (04) gebildet wird, ebenfalls mindestens eine Unterbrechung aufweist, sodass ein zu transportierendes mikromechanisches Bauelement (01) eine Energiebarriere überwinden muss.

9. Anordnung nach Anspruch 8, **dadurch gekennzeichnet, dass** die mindestens eine Unterbrechung der streifenförmigen Schicht (03) durch eine Verengung oder einen Spalt (13) gebildet wird.

10. Anordnung nach einem der Ansprüche 1 bis 9, **dadurch gekennzeichnet, dass** zwei parallele streifenförmige Schichten (03) der streifenförmigen Schichten (03) die Ausdehnung von zwei der Schienen auf dem Transportweg definieren.

11. Anordnung nach Anspruch 10 unter Bezugnahme auf Anspruch 8 oder 9, **dadurch gekennzeichnet, dass** die Unterbrechungen (13) der zwei Schienen versetzt sind, sodass sich an jedem Punkt des Transportwegs höchstens eine der Unterbrechungen (13) befindet.

12. Anordnung nach einem der Ansprüche 1 bis 11, **dadurch gekennzeichnet, dass** sie zwei der Transportwege und ein Mittel (26; 27; 29) zum Anwenden einer wählbaren Umlenkkraft auf das zu transportierende mikromechanische Bauelement (01) zum Umlenken des mikromechanischen Bauelements (01) von einem ersten der zwei Transportwege auf einen zweiten der zwei Transportwege umfasst.

13. Verfahren zum Transportieren mikromechanischer Bauelemente (01) auf einer Anordnung nach einem der Ansprüche 1 bis 12, wobei das Verfahren die folgenden Schritte umfasst:
- Platzieren mindestens eines mikromechanischen Bauelements (01) auf der flüssigen oder geschmolzenen Transportsubstanz (04); und
- Anwenden einer Antriebskraft auf das mikromechanische Bauelement (01) durch das Mittel (06; 20; 21) zum Anwenden einer Antriebskraft auf ein mikromechanisches Bauelement (01).

14. Verfahren nach Anspruch 13, **dadurch gekennzeichnet, dass** die Anordnung nach Anspruch 12 zum Transportieren der mikromechanischen Bauelemente (01) verwendet wird, wobei das Verfahren ferner den folgenden Schritt umfasst:
- Anwenden einer Umlenkkraft auf das mikromechanische Bauelement (01) durch das Mittel (26; 27; 29) zum Anwenden einer wählbaren Umlenkkraft zum Umlenken dieses mikromechanischen Bauelements (01) von dem ersten Transportweg auf den zweiten Transportweg.

15. Verfahren nach Anspruch 14, **dadurch gekennzeichnet, dass** mindestens zwei unterschiedliche der mikromechanischen Bauelemente (01) auf der flüssigen oder geschmolzenen Transportsubstanz (04) platziert werden, wobei das Verfahren ferner die folgenden Schritte umfasst:
- Detektieren eines ersten der zwei unterschiedlichen mikromechanischen Bauelemente (01);
- Vorbeilassen des detektierten ersten mikromechanischen Bauelements (01) an dem Mittel (26; 27; 29) zum Anwenden einer wählbaren Umlenkkraft, sodass das erste mikromechanische Bauelement (01) auf dem ersten Transportweg verbleibt;
- Detektieren eines zweiten der zwei unterschiedlichen mikromechanischen Bauelemente (01); und
- Anwenden einer gewählten Umlenkkraft auf das detektierte zweite mikromechanische Bauelement (01) durch das Mittel (26; 27; 29) zum Anwenden einer wählbaren Umlenkkraft, sodass das zweite mikromechanische Bauelement (01) von dem ersten Transportweg auf den zweiten Transportweg umgelenkt wird.

## Revendications

1. Agencement de transport de composants micromécaniques (01), dans lequel l'agencement comprend :
- au moins un substrat (02) qui s'étend sur un trajet de transport ;
- au moins une couche en forme de bande (03) sur le substrat (02) définissant l'étendue d'un rail sur le trajet de transport, dans lequel la couche (03) est constituée d'un matériau solide ;
- une substance de transport liquide ou fusible (04) sur la couche en forme de bande (03) ;
- au moins un moyen (06 ; 20 ; 21) d'application d'une force conductrice à un composant micromécanique (01) qui flotte sur la substance de transport (04) ; et
**caractérisé en ce que** la substance de transport (04) forme un rail et dans lequel une tension interfaciale entre la substance de transport (04) et le matériau solide de la couche en forme de bande (03) est inférieure à une tension interfaciale entre la substance de transport (04) et le substrat (02).

2. Agencement selon la revendication 1, **caractérisé en ce que** le substrat (02) et la couche (03) sont planaires.

3. Agencement selon la revendication 1 ou 2, **caractérisé en ce que** la substance de transport liquide ou fusible (04) est un alliage de soudure, un métal liquide, une huile ou de l'eau.

4. Agencement selon une des revendications 1 à 3, **caractérisé en ce qu'**il comprend en outre un tube (32) qui recouvre le substrat (02) et la substance de transport (04) qui forme le rail.

5. Agencement selon la revendication 4, **caractérisé en ce que** au moins un moyen d'application d'une force conductrice est formé par un milieu gazeux ou liquide (06), qui circule à travers le tube (32).

6. Agencement selon la revendication 5, **caractérisé en ce qu'**il comprend en outre un élément chauffant pour chauffer le milieu gazeux ou liquide (06) de sorte que la substance de transport liquide (04) puisse être fondue.

7. Agencement selon une des revendications 1 à 6, **caractérisé en ce que** au moins un moyen d'application d'une force conductrice est formé par un aimant permanent, par un électroaimant (20) ou par un actionneur pour incliner le substrat (02).

8. Agencement selon une des revendications 1 à 7, **caractérisé en ce que** la couche en forme de bande (03) comporte au moins une discontinuité (13) sur le trajet de transport, de sorte que le rail formé par la substance de transport liquide ou fusible (04) comporte aussi au moins une discontinuité, de sorte qu'un composant micromécanique (01) à transporter doive franchir une barrière énergétique.

9. Agencement selon la revendication 8, **caractérisé en ce que** la au moins une discontinuité de la couche en forme de bande (03) est formée par un rétrécissement ou un interstice (13).

10. Agencement selon une des revendications 1 à 9, **caractérisé en ce que** deux couches en forme de bande parallèles (03) des couches en forme de bande (03) définissent l'étendue de deux des rails sur le trajet de transport.

11. Agencement selon la revendication 10, qui se réfère aux revendications 8 ou 9, **caractérisé en ce que** les discontinuités (13) des deux rails sont décalées, de sorte que sur chaque point du trajet de transport se trouve au maximum une des discontinuités (13).

12. Agencement selon une des revendications 1 à 11, **caractérisé en ce qu'**il comprend deux des trajets de transport et un moyen (26 ; 27 ; 29) d'application d'une force de commutation sélectionnable vers le composant micromécanique (01) à transporter afin de commuter le composant micromécanique (01) d'un premier des deux trajets de transport à un deuxième des deux trajets de transport.

13. Procédé de transport de composants micromécaniques (01) sur un agencement selon une des revendications 1 à 12, dans lequel le procédé comprend les étapes suivantes :
- placement d'au moins un composant micromécanique (01) sur la substance de transport liquide ou fondue (04) ; et
- application d'une force de conduction à le composant micromécanique (01) par le moyen (06 ; 20 ; 21) d'application d'une force conductrice à un composant micromécanique (01).

14. Procédé selon la revendication 13, **caractérisé en ce que** l'agencement selon la revendication 12 est utilisé pour transporter les composants micromécaniques (01), dans lequel le procédé comprend en outre l'étape suivante :
- application d'une force de commutation au composant micromécanique (01) par le moyen (26 ; 27 ; 9) d'application d'une force de commutation sélectionnable afin de commuter ce composant micromécanique (01) du premier trajet de transport au deuxième trajet de transport.

15. Procédé selon la revendication 14, **caractérisé en ce que** au moins deux composants différents parmi les composants micromécaniques (01) sont placés sur la substance de transport liquide ou fondue (04), dans lequel le procédé comprend en outre les étapes suivantes :
- la détection d'un premier des deux composants micromécaniques différents (01) ;
- le passage du premier composant micromécanique détecté (01) à travers le moyen (26 ; 27 ; 29) d'application d'une force de commutation sélectionnable de sorte que le premier composant micromécanique (01) reste sur le premier trajet de transport ;
- la détection d'un deuxième des deux composants micromécaniques différents (01) ; et
- l'application d'une force de commutation sélectionné au deuxième composant micromécanique détecté (1) par le moyen (26 ; 27 ; 29) d'application d'une force de commutation sélectionnable de sorte que le deuxième composant micromécanique (01) soit commuté du premier trajet de transport au deuxième trajet de transport.
